(19) **Europäisches Patentamt**

**European Patent Office**

**Office européen des brevets**

(11) **EP 1 072 094 B1**

(12) **EUROPEAN PATENT SPECIFICATION**

(45) Date of publication and mention
of the grant of the patent:
**15.01.2003 Bulletin 2003/03**

(21) Application number: **99917010.3**

(22) Date of filing: **14.04.1999**

(51) Int Cl.⁷: **H03K 17/56**

(86) International application number:
**PCT/GB99/01141**

(87) International publication number:
**WO 99/053617 (21.10.1999 Gazette 1999/42)**

(54) **RADIO FREQUENCY SWITCH**

**HOCHFREQUENZSCHALTER**

**COMMUTATEUR RADIOFREQUENCE**

(84) Designated Contracting States:
**AT CH DE FI FR IT LI NL SE**

(30) Priority: **14.04.1998 GB 9807672**

(43) Date of publication of application:
**31.01.2001 Bulletin 2001/05**

(73) Proprietor: **ROKE MANOR RESEARCH LIMITED
Romsey, Hampshire SO51 0ZN (GB)**

(72) Inventor: **STEVENS, Roderick, Leonard, Wallace
Eastleigh,Hampshire SO53 4RG (GB)**

(74) Representative: **French, Clive Harry et al
Siemens AG,
PO Box 22 16 34
80506 München (DE)**

(56) References cited:
| | |
|---|---|
| EP-A- 0 436 861 | JP-A- 2 164 124 |
| JP-A- 3 159 311 | JP-A- 60 148 223 |
| US-A- 3 959 750 | US-A- 4 672 687 |
| US-A- 4 761 827 | US-A- 4 788 503 |
| US-A- 5 170 139 | |

## Description

The present invention relates to radio frequency switches which operate to communicate radio frequency signals from an input of the switch to an output of the switch in dependence upon a switching signal applied to a control input of the switch.

Switches for radio frequency signals must be effective to both isolate radio frequency signals applied to an input of the switch when the switch is in an 'off' state, whilst providing an efficient conduit for the radio frequency signals when the switch is in an 'on' state. Radio frequency switches must obviate a first technical problem of effectively isolating the input of the switch from the output when the switch is in the 'off' state. A second technical problem with current radio frequency switches is that they do not facilitate switching from the 'on' state to the 'off' state in a time which is fast enough to allow only a predetermined quantity of radio frequency energy to pass to the output.

Furthermore it is known to switch radio frequency signals between two independent antennas in dependence upon a switching signal. US-A-4499606 is an example of such a switch. Here, all semiconductor diode components are formed as a single semiconductor package and the bias applied to the semiconductor diodes is controlled by a digital logic means.

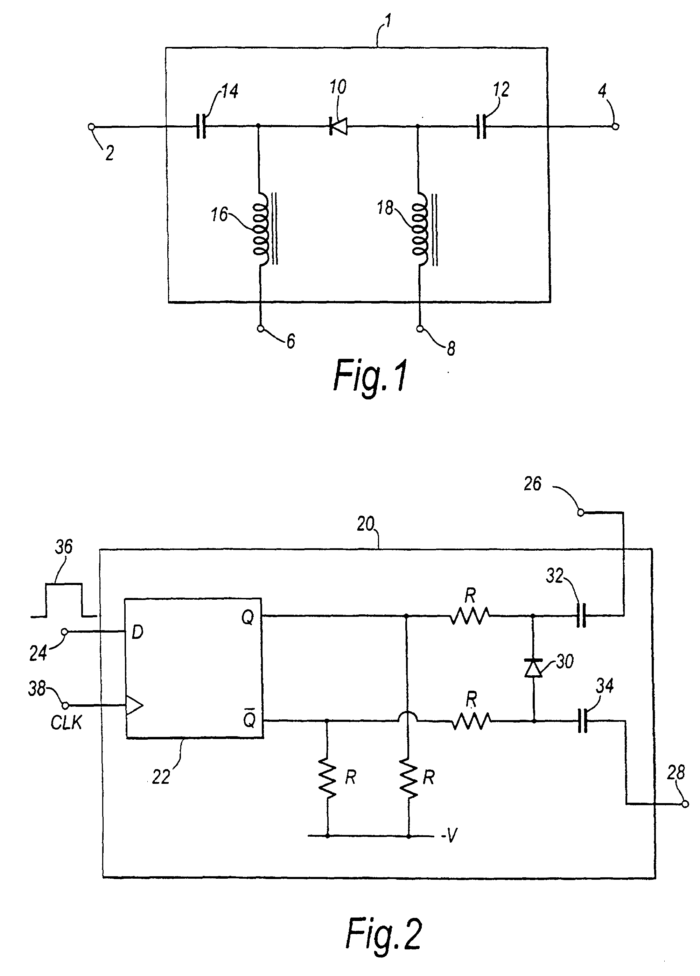

An example of a known radio frequency switch is illustrated in the schematic diagram shown in Figure 1. In Figure 1 a radio frequency switch 1 has an input 2 and an output 4 and a control input formed between two further terminals 6 and 8. The radio frequency switch 1 is comprised of a semiconductor diode 10 connected between the input 2 and output 4 via decoupling capacitors 12, 14. The control input terminals 6, 8, are connected across the cathode and anode respectively of the diode 10 via first and second radio frequency chokes 16, 18 respectively. In operation the known radio frequency switch shown in Figure 1 prevents signals applied to the input terminal 2 from reaching the output terminal 4 whilst the diode 10 is in an off state. The off state is therefore achieved by applying dc voltage between control input terminals 6, 8 to the effect that diode 10 is reverse biased. Correspondingly, radio frequency signals applied to the input terminal 2 wil be conveyed to the output terminal 4, when the diode 10 is conducting which is achieved by applying an appropriate DC voltage between the input control terminals 6, 8 which has an effect of forward biasing the diode 10.

A disadvantage with this known form of radio frequency switch is that when very high frequency signals are applied to an input of the switch, the radio frequency chokes 16, 18 may not be effective to prevent radio frequency signals from passing from the input terminal 2, through the radio frequency chokes 16, 18 via the terminals 6 and 8 to the output 4 of the switch 1, bypassing the diode 10. Thus for signals in the range between 1 to 10 GHz, this arrangement would not be satisfactory. Alternatively increased radio frequency isolation could be achieved by increasing the inductance of the radio frequency chokes 16, 18. However, this would have a disadvantage in that the time taken for the diode 10 to conduct will increase with the effect that a time taken for the switch 1 to change from an 'off' to the 'on' state will increase. As such the known radio frequency switch 1 may not be used to switch a radio frequency signal of a substantially short duration between the input 2 and the output 4.

The aforementioned disadvantages of isolating a high frequency signal between an input and an output of a radio frequency switch and arranging for the switch to change from an 'off' to an 'on' state quickly, represents a technical problem which is addressed by the present invention.

According to the present invention there is provided a radio frequency switch which operates to communicate a radio frequency signal from an input of the switch to an output of the switch in accordance with a control signal applied to a control input of the switch, said radio frequency switch comprising: first and second pairs of semiconductor diodes, wherein the first pair of semiconductor diodes are connected in series, the second pair of semiconductor diodes are also connected in series and the first pair is connected in parallel with the second pair, and the input of the radio frequency switch is coupled to a junction between the first pair of semiconductor diodes and the output of the radio frequency switch is coupled to a junction between the second pair of semiconductor diodes; and a digital logic means having a first output generating a first DC voltage and a second output generating an inverse of the first DC voltage and an activating input coupled to the control input of the radio frequency switch, wherein the first output of said digital logic means is coupled to a cathode of each of said pairs of serially connected semiconductor diodes and the second output of said digital logic means is coupled to an anode of each of said pairs of serially connected semiconductor diodes and the first voltage and the inverse of the first voltage have an effect of reverse biasing said semiconductor diode when said digital logic means is in a first state and consequent upon a change in said control signal fed to the activating input of said digital logic means, said digital logic means changes to a second state in which said first output generates the inverse of the first voltage and said second output generates the first voltage thereby forward biasing said semiconductor diode and connecting the input of the switch to the output of the switch;

    characterised in that the first and second pairs of semiconductor diodes are fabricated in separate semiconductor packages thereby substantially improving radio frequency isolation between the input and the output of the switch.

By using a digital logic means to reverse bias the diode when the switch is in the off state and to forward bias the diode when the switch is in the on state, radio frequency isolation may be effected whilst providing a fast switching time as a result of the comparatively fast operation of the digital logic means. The digital logic means may comprise digital logic gates fabricated in accordance with emitter coupled logic. The digital logic means may be a flip-flop. The flip-flop may be a D-type flip-flop.

Embodiments of the present invention will now be described with reference to the accompanying drawings wherein,

FIGURE 2 is a schematic block diagram of a first embodiment of a radio frequency switch,
FIGURE 3 is a schematic block diagram of a second embodiment of the radio frequency switch,

In Figure 2, a radio frequency switch 20 is shown to be comprised of a D-type flip-flop 22 which has a $Q$ and a $\bar{Q}$ output which serve to generate DC voltages of +V and -V respectively when the control input (D) 24 is at a low DC voltage on the active transition of a clock signal CLK applied to clock input 38. Connected between an input 26 of the switch 20 and an output 28 of the switch 20, is a diode 30, which is AC coupled to the input 26 and output 28 via capacitors 32, 34. The circuit is completed by biasing resistors R which arrange for the $Q$ and $\bar{Q}$ outputs from the flip-flop 22 to be coupled to the anode and cathode of the diode 30. The biasing resistors R serve to maintain the diode 30 in reverse bias mode whilst the flip-flop 22 is arranged to be in a first mode where the $Q$ output generates the positive DC voltage +V and $\bar{Q}$ output generates the negative DC voltage -V. It is a feature of this switch 20 that the flip-flop 22 is comprised of emitter coupled logic gates which provide the flip-flop with a switching time in the order of 50 psec. However, as will be appreciated other semiconductor active components and logic designs may also be used. When a switching pulse 36 is received and applied to the input 24 of the flip-flop 22, the flip-flop switches on the active transition of a clock signal CLK applied to clock input 38, such that the $\bar{Q}$ output is positive +V whilst the $Q$ output is negative -V. This has the effect of forward biasing the diode 30, thereby causing the diode 30 to conduct, which in turn has the effect that the input 26 is connected to the output 28, thereby passing the signal from the input 26 to the output 28 whilst the control input 24 is high. With this switch arrangement a switching time in the order of 50 pico seconds may be effected, such that the radio frequency switch 20 may operate to convey a radio frequency pulse with a duration in the order of 500ps with a distortion period caused by switching in the order of only 10% of this duration.

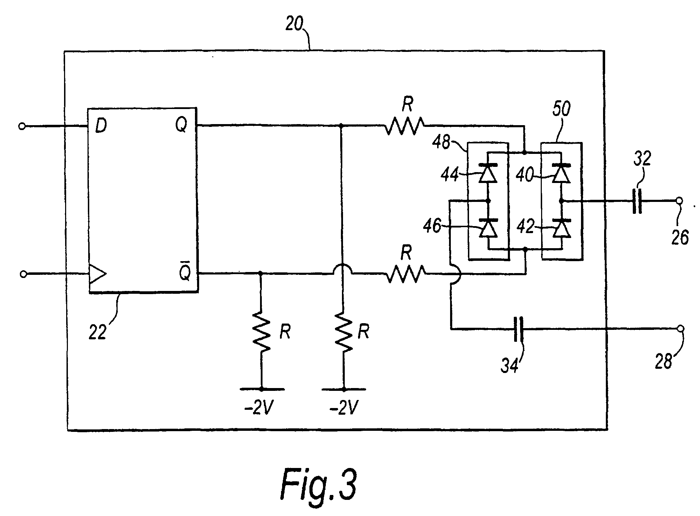

A further preferred embodiment of the present invention is illustrated in Figure 3 where parts also appearing in Figure 2 bear identical numerical designations. The radio frequency switch shown in Figure 3 is the same radio frequency switch shown in Figure 2 apart from the replacement of the diode 30 by two pairs of diodes 40, 42, 44, 46. Furthermore, the input and output of the radio frequency switch which are connected to the two pairs of diodes. The diode 30 has been replaced by the two pairs of serially connected diodes 40, 42, 44, 46, each of which pair is connected in parallel with the other pair and connected between the $Q$ and $\bar{Q}$ outputs of the flip-flop 22. The input 26 of the radio frequency switch 20 is connected, via capacitor 32, between the junction between the first pair 40, 42 of serially connected diodes and the output 28 of the radio frequency switch is connected, via capacitor 34, to the junction between the second pair 44, 46 of serially connected diodes. The first pair of diodes 40, 42 is formed in a first semiconductor package 50 whereas the second pair of diodes 44, 46 is formed in a second semiconductor package 48.

An effect of the arrangement of replacing the diode 30 with the first and second pairs of semiconductor diodes is that a radio frequency isolation between the input 26 and the output 28 of the switch is improved. Otherwise, operation of the radio frequency switch shown in Figure 3 is substantially in accordance with that described for Figure 2 and so will not be repeated here. A further improvement in isolation is effected by arranging for the first and second pairs of diodes to be fabricated in the separate semiconductor packages 48, 50.

As will be appreciated by those skilled in the art, various modifications may be made to the aforementioned embodiments whilst still falling within the scope of the present invention.

**Claims**

1. A radio frequency switch (20) which operates to communicate a radio frequency signal from an input (26) of the switch to an output (28) of the switch in accordance with a control signal applied to a control input (24) of the switch, said radio frequency switch (20) comprising:

   first and second pairs (50,48) of semiconductor diodes, wherein the diodes of the first pair (50) of semiconductor diodes (40,42) are connected in series, the diodes of the second pair (48) of semiconductor diodes (44,46) are also connected in series and the first pair (50) is connected in parallel with the second pair (48), wherein the input (26) of the radio frequency switch is coupled to a junction between the diodes of the first pair of semiconductor diodes and wherein the output (28) of the radio frequency switch is coupled to a junction between the diodes of the second pair of semiconductor diodes; and
   a digital logic means (22) having a first output (Q) generating a first DC voltage (+V) and a second output ($\bar{Q}$) generating an inverse of the first DC voltage (-V) and an activating input (D) coupled to the control input (24) of the radio frequency switch (20), wherein the first output (Q) of said digital logic means (22) is coupled to a cathode of each of said pairs (50,48) of serially connected semiconductor diodes (50,48) and the second output ($\overline{Q}$) of said digital logic means (22) is coupled to an anode of each of said pairs (50,48) of serially connected semiconductor diodes (50,48) and the first voltage (+V) and the inverse of the first voltage (-V) have an effect of reverse biasing said semiconductor diodes (40,42,44,46) when said digital logic means (22) is in a first state and consequent upon a change in said control signal fed to the activating input (D) of said digital logic means, said digital logic means (22) changes to a second state in which said first output (Q) generates the inverse of the first voltage (-V) and said second output ($\overline{Q}$) generates the first voltage (+V) thereby forward biasing said semiconductor diodes (40,42,44,46) and connecting the input (26) of the switch to the output (28) of the switch,

**characterised in that**:

the first and second pairs of semiconductor diodes (50,48) are fabricated in separate semiconductor packages thereby substantially improving radio frequency isolation between the input (26) and the output (28) of the switch.

2. A radio frequency switch as claimed in Claim 1, wherein said digital logic means (22) is comprised of digital logic gates fabricated in accordance with emitter coupled logic.

3. A radio frequency switch as claimed in Claims 1 or 2, wherein said digital logic means (22) is a flip-flop.

4. A radio frequency switch as claimed in Claim 3, wherein the flip-flop is a D-type flip-flop.

**Patentansprüche**

1. Hochfrequenzschalter (20), der wirkt, um ein Hochfrequenzsignal gemäß einem an einen Steuereingang (24) des Schalters angelegten Steuersignal von einem Eingang (26) des Schalters zu einem Ausgang (28) des Schalters zu übermitteln, wobei der Hochfrequenzschalter (20) folgendes umfaßt:

ein erstes und ein zweites Paar (50, 48) von Halbleiterdioden, wobei die Dioden des ersten Paars (50) von Halbleiterdioden (40, 42) in Reihe geschaltet sind, die Dioden des zweiten Paars (48) von Halbleiterdioden (44, 46) ebenfalls in Reihe geschaltet sind und das erste Paar (50) mit dem zweiten Paar (48) parallel geschaltet ist, wobei der Eingang (26) des Hochfrequenzschalters an einen Schaltungsknoten zwischen den Dioden des ersten Paars von Halbleiterdioden angekoppelt ist und wobei der Ausgang (28) des Hochfrequenzschalters an einen Schaltungsknoten zwischen den Dioden des zweiten Paars von Halbleiterdioden angekoppelt ist; und

ein digitales Logikmittel (22) mit einem ersten Ausgang (Q), der eine erste Gleichspannung (+V) erzeugt, und einem zweiten Ausgang ($\overline{Q}$), der eine Umkehrung der ersten Gleichspannung (-V) erzeugt, und einem Aktivierungseingang (D), der an den Steuereingang (24) des Hochfrequenzschalters (20) angekoppelt ist, wobei der erste Ausgang (Q) des digitalen Logikmittels (22) an eine Kathode jedes der Paare (50, 48) in Reihe geschalteter Halbleiterdioden (50, 48) und der zweite Ausgang ($\overline{Q}$) des digitalen Logikmittels (22) an eine Anode jedes der Paare (50, 48) in Reihe geschalteter Halbleiterdioden (50, 48) angekoppelt ist und die erste Spannung (+V) und die Umkehrung der ersten Spannung (-V) die Wirkung haben, die Halbleiterdioden (40, 42, 44, 46) in Sperrichtung vorzuspannen, wenn sich das digitale Logikmittel (22) in einem ersten Zustand befindet, und als Folge einer Änderung des dem Aktivierungseingang (D) des digitalen Logikmittels zugeführten Steuersignals das digitale Logikmittel (22) zu einem zweiten Zustand wechselt, in dem der erste Ausgang (Q) die Umkehrung der ersten Spannung (-V) und der zweite Ausgang ($\overline{Q}$) die erste Spannung (+V) erzeugt, wodurch die Halbleiterdioden (40, 42, 44, 46) in Vorwärtsrichtung vorgespannt werden und der Eingang (26) des Schalters mit dem Ausgang (28) des Schalters verbunden wird,

**dadurch gekennzeichnet, daß**
das erste und das zweite Paar von Halbleiterdioden (50, 48) in getrennten Halbleiterbausteinen hergestellt werden, wodurch die Hochfrequenzisolation zwischen dem Eingang (26) und dem Ausgang (28) des Schalters wesentlich verbessert wird.

2. Hochfrequenzschalter nach Anspruch 1, wobei das digitale Logikmittel (22) aus digitalen Logikgattern besteht, die gemäß der emittergekoppelten Logik hergestellt sind.

3. Hochfrequenzschalter nach Anspruch 1 oder 2, wobei das digitale Logikmittel (22) ein Flipflop ist.

**4.** Hochfrequenzschalter nach Anspruch 3, wobei das Flipflop ein D-Flipflop ist.

**Revendications**

**1.** Commutateur radiofréquence (20) qui a pour fonction de transmettre un signal radiofréquence d'une entrée (26) du commutateur à une sortie (28) du commutateur en conformité avec un signal de commande appliqué à une entrée de commande (24) du commutateur, le commutateur radiofréquence (20) comprenant :

des première et deuxième paires (50, 48) de diodes à semi-conducteur, dans lequel les diodes de la première paire (50) de diodes à semi-conducteur (40, 42) sont connectées en série, les diodes de la deuxième paire (48) de diodes à semi-conducteur (44, 46) sont également connectées en série et la première paire (50) est connectée en parallèle avec la deuxième paire (48), dans lequel l'entrée (26) du commutateur radiofréquence est reliée à une jonction entre les diodes de la première paire de diodes à semi-conducteur et dans lequel la sortie (28) du commutateur radiofréquence est relié à une jonction entre les diodes de la deuxième paire de diodes à semi-conducteur ; et
un moyen logique numérique (22) ayant une première sortie (Q) produisant une première tension continue (+V) et une deuxième sortie ($\overline{Q}$) produisant un inverse de la première tension continue (-V) et une entrée d'activation (D) reliée à l'entrée de commande (24) du commutateur radiofréquence (20), dans lequel la première sortie (Q) du moyen logique numérique (22) est reliée à une cathode de chacune des paires (50, 48) de diodes à semi-conducteur connectées en série (50, 48) et la deuxième sortie ($\overline{Q}$) du moyen logique numérique (22) est reliée à une anode de chacune de la paire (50, 48) de diodes à semi-conducteur connectées en série (50, 48) et la première tension (+V) et l'inverse de la première tension (-V) ont pour effet de polariser en sens inverse les diodes à semi-conducteur (40, 42, 44, 46) lorsque le moyen logique numérique (22) est dans un premier état et, consécutivement à une modification du signal de commande appliqué à l'entrée d'activation (D) du moyen logique numérique, le moyen logique numérique (22) passe dans un deuxième état dans lequel la première sortie (Q) produit l'inverse de la première tension (-V) et la deuxième sortie ($\overline{Q}$) produit la première tension (+V) en polarisant ainsi en sens direct les diodes à semi-conducteur (40, 42, 44, 46) et en connectant l'entrée (26) du commutateur à la sortie (28) du commutateur,

**caractérisé en ce que** :

les première et deuxième paires de diodes à semi-conducteur (50, 48) sont fabriquées dans des boîtiers séparés de semi-conducteurs, afin d'améliorer ainsi sensiblement l'isolation radiofréquence entre l'entrée (26) et la sortie (28) du commutateur.

**2.** Commutateur radiofréquence suivant la revendication 1, dans lequel le moyen logique numérique (22) est constitué de portes logiques numériques réalisées conformément à une logique à couplage par émetteur.

**3.** Commutateur radiofréquence suivant la revendication 1 ou 2, dans lequel le moyen logique numérique (22) est une bascule.

**4.** Commutateur radiofréquence suivant la revendication 3, dans lequel la bascule est une bascule de type D.

Fig.1

Fig.2

*Fig.3*